(19) Europäisches Patentamt / European Patent Office / Office européen des brevets

(11) **EP 3 832 354 B1**

(12) **FASCICULE DE BREVET EUROPEEN**

(45) Date de publication et mention de la délivrance du brevet:
**30.08.2023 Bulletin 2023/35**

(21) Numéro de dépôt: **20208067.7**

(22) Date de dépôt: **17.11.2020**

(51) Classification Internationale des Brevets (IPC):
**G01V 1/30** (2006.01)   **G01V 99/00** (2009.01)

(52) Classification Coopérative des Brevets (CPC):
**G01V 1/302; G01V 1/308; G01V 99/005;**
G01V 2210/673

(54) **PROCÉDÉ POUR MODÉLISER UN BASSIN SÉDIMENTAIRE, AU MOYEN D'UNE REPRÉSENTATION MAILLÉE HEXA-DOMINANTE**

VERFAHREN ZUR MODELLIERUNG EINES SEDIMENTBECKENS MIT HILFE EINER HEXA-DOMINANTEN NETZDARSTELLLUNG

METHOD FOR MODELLING A SEDIMENTARY BASIN, USING A HEX-DOMINANT MESH REPRESENTATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.12.2019 FR 1913783**

(43) Date de publication de la demande:
**09.06.2021 Bulletin 2021/23**

(73) Titulaires:
• **IFP Energies nouvelles**
  **92852 Rueil-Malmaison Cedex (FR)**
• **TotalEnergies OneTech**
  **92400 Courbevoie (FR)**

(72) Inventeur: **COLOMBO, Daniele**
  **92852 RUEIL-MALMAISON CEDEX (FR)**

(74) Mandataire: **IFP Energies nouvelles**
  **Département Propriété Industrielle**
  **Rond Point de l'échangeur de Solaize**
  **BP3**
  **69360 Solaize (FR)**

(56) Documents cités:
**US-A1- 2015 066 460**

• **LI Y H ET AL: "Highly accurate smoothed finite element methods based on simplified eight-noded hexahedron elements", ENGINEERING ANALYSIS WITH BOUNDARY ELEMENTS, vol. 105, 12 juillet 2009 (2009-07-12), pages 165-177, XP085694954, ISSN: 0955-7997, DOI: 10.1016/J.ENGANABOUND.2019.03.020**
• **NGUYEN-THOI T ET AL: "A face-based smoothed finite element method (FS-FEM) for visco-elastoplastic analyses of 3D solids using tetrahedral mesh", COMPUTER METHODS IN APPLIED MECHANICS AND ENGINEERING, NORTH-HOLLAND, AMSTERDAM, NL, vol. 198, no. 41-44, 1 septembre 2009 (2009-09-01), pages 3479-3498, XP026574218, ISSN: 0045-7825, DOI: 10.1016/J.CMA.2009.07.001 [extrait le 2009-07-12]**

**Description**

**Domaine technique**

La présente invention concerne le domaine de l'exploration et de l'exploitation des gisements pétroliers ou de sites de stockage géologique de gaz.

L'exploration pétrolière consiste à rechercher des gisements d'hydrocarbures au sein d'un bassin sédimentaire. La compréhension des principes de la genèse des hydrocarbures et leurs liens avec l'histoire géologique du sous-sol, a permis la mise au point de méthodes d'évaluation du potentiel pétrolier d'un bassin sédimentaire.

La démarche générale de l'évaluation du potentiel pétrolier d'un bassin sédimentaire comporte des allers-retours entre :

- une prédiction du potentiel pétrolier du bassin sédimentaire, réalisée à partir d'informations disponibles concernant le bassin étudié (affleurements, campagnes sismiques, forages par exemple). Cette prédiction vise à mieux comprendre l'architecture et l'histoire géologique du bassin étudié, notamment à étudier si des processus de maturation et de migration d'hydrocarbures ont pu se mettre en place, à identifier les zones du sous-sol dans lesquelles ces hydrocarbures ont pu s'accumuler, à définir quelles zones présentent le meilleur potentiel économique, évalué à partir du volume et de la nature des hydrocarbures probablement piégés (viscosité, taux de mélange avec de l'eau, composition chimique, etc), ainsi que de leur coût d'exploitation (contrôlé par exemple par la profondeur et la pression de fluide).

- des forages d'exploration dans les différentes zones présentant le meilleur potentiel, afin de confirmer ou infirmer le potentiel prédit préalablement, et d'acquérir de nouvelles données pour alimenter de nouvelles études plus précises.

L'exploitation pétrolière d'un gisement consiste, à partir des informations récoltées lors de la phase d'exploration pétrolière, à sélectionner les zones du gisement présentant le meilleur potentiel pétrolier, à définir des schémas d'exploitation optimaux pour ces zones (par exemple à l'aide d'une simulation de réservoir, afin de définir les nombre et positions des puits d'exploitation permettant une récupération d'hydrocarbures optimale), à forer des puits d'exploitation et, de façon générale, à mettre en place les infrastructures de production nécessaires au développement du gisement.

Un bassin sédimentaire résulte du dépôt, au cours des temps géologiques, de sédiments au sein d'une dépression de la croûte terrestre. Ces sédiments, meubles et riches en eau vont être soumis, lors de leur enfouissement progressif dans le bassin, à des conditions de pression et de température qui vont les transformer en roches sédimentaires compactes, dites couches géologiques.

L'architecture au temps actuel d'un bassin sédimentaire résulte notamment d'une déformation mécanique du sous-sol au cours des temps géologiques. Cette déformation comporte a minima une compaction des couches géologiques, due à l'enfouissement progressif de ces couches au sein du bassin, sous l'effet de l'arrivée de nouveaux sédiments. Mais un bassin sédimentaire est également le plus souvent soumis à des mouvements tectoniques de grande ampleur, générant par exemple des plissements des couches géologiques, ou encore des failles venant créer une rupture dans les couches géologiques.

La nature des hydrocarbures présents dans un bassin sédimentaire quant à elle résulte notamment du type de matière organique présente dans les sédiments s'étant déposés, mais aussi des conditions de pression et de température auxquelles est soumis le bassin au cours des temps géologiques.

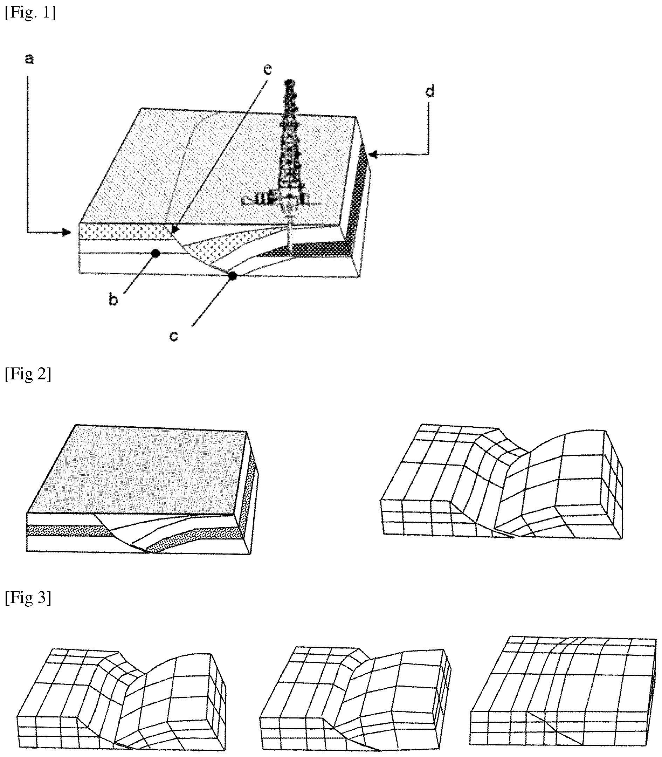

La Figure 1 montre une représentation schématique d'un bassin sédimentaire, comportant plusieurs couches géologiques (a, c), délimitées par des interfaces sédimentaires (b) traversées par une faille (e), et une accumulation d'hydrocarbures (d) dans une des couches géologiques du bassin considéré (c).

La formation d'un bassin sédimentaire implique donc un grand nombre de processus physiques et chimiques complexes, pouvant qui plus est interagir entre eux. Face à cette complexité, la prédiction du potentiel pétrolier d'un bassin sédimentaire requiert de disposer d'outils informatiques permettant de simuler, de la façon la plus réaliste possible, les phénomènes physiques et chimiques impliqués lors de la formation du bassin étudié.

Ce type de reconstitution de l'histoire de la formation d'un bassin sédimentaire, aussi appelée « modélisation de bassin », est le plus souvent réalisée à l'aide d'une famille d'outils informatiques permettant de simuler en une, deux ou trois dimensions, les processus sédimentaires, tectoniques, thermiques, hydrodynamiques et de chimie organique et inorganique qui interviennent lors de la formation d'un bassin pétrolier.

La modélisation de bassin comporte classiquement trois étapes :

- une étape de construction d'une représentation maillée du bassin étudié, connue sous le terme de géo-modélisation. Cette représentation maillée (aussi appelée maillage) est le plus souvent structurée en couches, c'est-à-dire qu'un groupe de mailles est affecté à chaque couche géologique du bassin modélisé. Puis, chaque maille de cette représentation maillée est remplie par une ou plusieurs propriétés pétrophysiques, telles que la porosité, le faciès (argile, sable, etc) ou encore leur teneur en matière organique au moment de leur sédimentation. La construction de ce modèle se base sur des données acquises au cours de campagnes sismiques, de mesures dans des puits, de carottages, etc.

- une étape de reconstruction structurale de cette représentation maillée, représentant des états antérieurs de l'architecture du bassin. Cette étape peut être réalisée à l'aide d'une méthode dite de "backstripping", ou encore par une méthode dite de restauration structurale.

- une étape de simulation numérique de phénomènes physiques se déroulant au cours de l'évolution du bassin et contribuant à la formation des pièges pétroliers. Cette étape, connue sous le terme de « simulation de bassin », s'appuie sur une représentation discrétisée de l'espace et du temps pour reconstituer la formation du bassin au cours des temps géologiques. En particulier, la simulation de bassin permet de simuler, au cours des temps géologiques, la formation des hydrocarbures à partir notamment de la matière organique initialement enfouie avec les sédiments, l'état des contraintes et des déformations dans le bassin, et le transport de ces hydrocarbures, depuis les roches dans lesquelles ils se sont formés jusqu'à celles où ils sont piégés. A l'issue d'une simulation de bassin, on obtient ainsi une cartographie du sous-sol au temps actuel, indiquant l'emplacement probable des gisements, ainsi que la teneur, la nature et la pression des hydrocarbures qui y sont piégés. Un exemple d'un tel simulateur de bassin est le logiciel TEMISFLOW® (IFP Énergies nouvelles, France).

Ainsi, cette démarche intégrée permettant la prise en compte et l'analyse des phénomènes à l'origine de la génération, de la migration et de l'accumulation des hydrocarbures dans les bassins sédimentaires permet d'augmenter le taux de succès lors d'un forage d'un puits d'exploration, et permet ainsi une meilleure exploitation de ce bassin.

**Technique antérieure**

Les documents suivants seront cités au cours de la description :

Cook, Robert D., Finite Elément Modeling for Stress Analysis, John Wiley & Sons, 1995.

Coussy, O., Mécanique des milieux poreux, Editions Technip, 1991, Paris.

Liu, G.R., Nguyen Thoi Trung, Smoothed Finite Element Methods, CRC Press, 2010.

Schneider F., Modelling multi-phase flow of petroleum at the sedimentary basin scale. Journal of Geochemical exploration 78-79 (2003) 693-696).

Steckler, M.S., and A.B. Watts, Subsidence of the Atlantic-type continental margin off New York, Earth Planet. Sci. Lett., 41, 1-13, 1978.

Zienkiewicz, O.C., Taylor, R.L., The finite element method - Volume 1 : the basis - Fifth Edition, Butterworth Heinemann, 2000.

On connait des outils de simulation de bassin qui permettent de simuler numériquement la formation d'un bassin sédimentaire. On citera par exemple l'outil décrit dans le brevet EP2110686 (US8150669) ou les demandes de brevet EP2816377 (US2014/0377872), EP3075947 (US2016/0290107), EP3182176 (US2017/0177764). Ces outils permettent notamment d'estimer l'évolution de quantités telles que la température et la pression dans l'ensemble d'un bassin sédimentaire au cours des temps géologiques, et ainsi de simuler, au cours des temps géologiques, à la fois la transformation de la matière organique présente dans une roche mère du bassin en hydrocarbures, et la migration dans une roche réservoir du bassin des hydrocarbures ainsi produits.

Très classiquement, comme décrit par exemple dans le document (Schneider, 2003), les logiciels de simulation de bassin font une hypothèse de variations uniquement verticales des contraintes mécaniques affectant un bassin sédimentaire. Plus précisément, les logiciels de simulation de bassin ne prennent en compte que la composante verticale des variations de contraintes mécaniques induites par le poids des dépôts sédimentaires successifs au cours du temps. On parle alors de simulation 1D des effets mécaniques.

Toutefois, un bassin sédimentaire peut être soumis au cours de son histoire à des contraintes mécaniques caractérisées par des composantes dans les trois dimensions de l'espace, ces contraintes pouvant être locales ou régionales, et variables au cours du temps. Ces contraintes mécaniques sont d'une part induites par les dépôts de sédiments eux-mêmes. Dans ce cas, les contraintes mécaniques comportent une composante verticale, liée au poids des sédiments sur les couches déjà déposées, mais comporte le plus souvent également des composantes horizontales, ainsi que des composantes de cisaillement, les dépôts sédimentaires n'étant généralement pas invariants latéralement. D'autre part, un bassin sédimentaire subit, tout au long de sa formation, des contraintes mécaniques induites par des mouvements tectoniques liés à la géodynamique terrestre, tels que des mouvements en extension (provoquant l'ouverture du bassin avec par exemple la formation de rift) ou encore des mouvements en compression (provoquant des plissements, des chevauchements, des fractures au sein du bassin etc). Ces mouvements tectoniques induisent le plus souvent des variations de contraintes mécaniques dans les trois dimensions de l'espace. A noter qu'une couche déjà déposée va subir des variations de contraintes induites par les mouvements tectoniques auxquels est soumis un bassin sédimentaire tout au long de sa formation.

Ainsi, dans le cas de tels bassins, on a besoin d'une modélisation très précise du champ de contraintes et le modèle vertical n'est plus satisfaisant. On connait le document EP 3182176 (US 10296679) qui concerne un couplage entre un simulateur de bassin classique (c'est-à-dire comprenant une simulation 1D des effets mécaniques) et un simulateur mécanique, qui permet de déterminer et de tenir compte du champ de déplacement et des contraintes en 3 dimensions dans une simulation de modélisation de bassin. Le couplage décrit dans ce document permet de réaliser les calculs thermique, hydrodynamique et mécanique sur une seul et même représentation maillée.

De manière générale, les représentations maillées utilisées en simulation de bassin doivent être hexaèdres-dominants (ou encore hexa-dominant) et conformes aux limites entres couches stratigraphiques afin que les modélisations hydrodynamiques soient les plus précises possibles. Or, parfois, certains bassins comportent une succession de couches géologiques très fines (quelques mètres, alors que les dimensions classiques d'un modèle de bassin sont de l'ordre de la centaine de km dans les deux directions horizontales et de l'ordre de 10 à 20 km dans la direction verticale) ayant des propriétés mécaniques et hydrauliques très hétérogènes et/ou des couches stratigraphiques biseautées, caractéristiques qui doivent être prises en compte dans la représentation maillée du bassin en vue d'une simulation numérique précise.

Couches fines et biseaux sont deux objets géométriques qui rendent très complexe la génération du maillage à utiliser pour la modélisation de bassin, notamment pour la simulation du comportement mécanique. De manière classique, la simulation du comportement mécanique est réalisée par la méthode des éléments finis, aussi connue sous l'acronyme FEM ("Finite Elément Method"). La qualité de la solution qu'on peut obtenir avec cette méthode dépend de la taille des mailles du maillage (la précision augmente avec le raffinement du maillage) et de leur forme. Dans le cas idéal, la géométrie de la maille doit être régulière et son rapport de forme (rapport entre les longueurs de sa plus petite arête et sa plus grande arête) doit être égale à 1 : une maille hexaédrique devrait être idéalement un cube, une maille tétraédrique devrait être idéalement un tétraèdre régulier, et ainsi de suite. En présence de couches fines et biseaux, le respect de ces conditions conduirait inévitablement à la génération de maillages avec un nombre très élevé de mailles, ce qui rend les algorithmes qui utilisent ces maillages inutilisables à cause de l'augmentation excessive de la demande en mémoire et en temps de calcul. Dans le cas des biseaux, il est même impossible de respecter la condition sur la géométrie de la maille, même en augmentant énormément le raffinement du maillage : la présence d'angles très faibles au niveau de l'extrémité du biseau fait apparaitre des mailles aplaties ou distordues indépendamment du niveau de raffinement. Dans certains cas, la géométrie défavorable de ces mailles crée des problèmes numériques qui empêchent la simulation d'aboutir.

Dans la pratique, en cas de couches fines ou de biseaux stratigraphiques, de manière à limiter le nombre de mailles à utiliser pour la simulation numérique, il est classique d'utiliser des mailles ayant une extension latérale de un à plusieurs kilomètres, alors qu'elles ne font que quelques mètres dans le sens vertical. Par ailleurs, la présence de biseaux stratigraphiques impose en plus d'être capable de traiter des mailles dont les faces sont raccordées suivant un angle très faible, de l'ordre de 1° par exemple. Ainsi, certains cas d'application pratique de la simulation numérique de bassin ne permettent pas de générer un maillage pour lequel les conditions sur la forme de la maille sont vérifiées, ce qui a pour conséquence que la qualité de la simulation numérique de bassin n'est pas garantie. Dans certain cas, il se peut même que la méthode numérique ne puisse trouver une solution.

Pour pallier ces inconvénients, il est possible d'utiliser la méthode FS-FEM (pour "Face-based Smoothed Finite Elément Method"), ou méthode aux éléments finis lissée basée sur les faces, comme présenté dans le document de Li Y.H. et al "Highly accurate smoothed finite element methods based on simplified eight-noded hexahedron éléments", Engenieering Analysis with Boundary Elements, Volume 105, Août 2019, pages 165-177.

La méthode FS-FEM est une déclinaison de la méthode aux éléments finis lissée (S-FEM, pour "Smoothed Finite Element Method"), qui est elle-même une variante de la méthode FEM. Chaque déclinaison de la méthode S-FEM a ses propriétés de convergence et de précision. La déclinaison FS-FEM est connue comme étant la déclinaison de la méthode S-FEM la plus précise.

Toutefois, comme cela sera démontré ci-après, il s'avère que l'application de la méthode FS-FEM pour résoudre l'équation d'équilibre de la poromécanique est instable dans le cas d'un maillage hexa-dominant présentant des mailles aplaties (rapport de la plus petite arête verticale sur la plus grande arête verticale valant au plus 1/5, préférentiellement 1/10). Or, en pratique, afin de ne pas augmenter démesurément le nombre de mailles de la simulation numérique de bassin, les couches fines et les biseaux stratigraphiques sont bien souvent représentés par des mailles aplaties.

La présente invention vise à pallier ces inconvénients. En particulier, la présente invention permet de résoudre numériquement, de manière stable et garantissant la qualité de la solution, les équations impliquées dans une simulation numérique de bassin, en particulier l'équation d'équilibre de la poromécanique au moyen d'une méthode aux éléments finis lissée basée sur les faces, même dans le cas d'un maillage hexa-dominant représentant des couches fines et/ou des biseaux stratigraphiques.

## Résumé de l'invention

La présente invention concerne un procédé de modélisation d'un bassin sédimentaire, ledit bassin sédimentaire ayant subi une pluralité d'événements géologiques définissant une séquence d'états dudit bassin, au moyen d'une simulation numérique de bassin exécutée sur ordinateur, ladite simulation numérique de bassin résolvant au moins une équation d'équilibre de la poromécanique selon une méthode aux éléments finis lissée basée sur les faces pour déterminer au moins un champ de contrainte et un champ de déformation. Le procédé selon l'invention comprend la mise en oeuvre d'au moins les étapes suivantes :

A. on réalise des mesures de grandeurs physiques relatives audit bassin au moyen de capteurs, et on construit une représentation maillée représentative dudit bassin pour chacun desdits états dudit bassin, lesdites représentations maillée dudit bassin pour chacun desdits états étant majoritairement formées par des mailles hexaédriques ;
B. au moyen de ladite simulation numérique de bassin et desdites représentations maillées pour chacun desdits états, on détermine au moins un champ de déformation et un champ de contrainte pour chacun desdits états en appliquant au moins les étapes suivantes pour chacune desdites représentations maillées desdits états :

a) on subdivise chacune desdites mailles hexaédriques de ladite représentation maillée en au moins huit sous-mailles hexaédriques ;
b) pour chacune des faces de chacune desdites sous-mailles, on détermine un domaine de lissage selon la méthode des éléments finis lissée basée sur les faces appliquée auxdites sous-mailles ;
c) pour chacun desdits domaines de lissage, on détermine une relation entre déformations et déplacements selon la méthode des éléments finis lissée basée sur les faces appliquée auxdits domaines de lissage ;
d) pour chacun desdits domaines de lissage, on détermine une relation de passage entre les degrés de liberté des noeuds desdites sous-mailles qui contiennent ledit domaine de lissage et les degrés de liberté des noeuds de ladite au moins une maille à laquelle appartient lesdites sous-mailles ;
e) on détermine une rigidité et des forces nodales pour chacun desdits domaines de lissage à partir au moins de ladite relation de passage déterminée pour ledit domaine de lissage et de ladite relation entre déformations et déplacements déterminée pour ledit domaine de lissage ;
f) on détermine une rigidité et des forces nodales relatives à ladite représentation maillée à partir au moins de ladite rigidité et desdites forces nodales déterminées pour chacun desdits domaines de lissage ;
g) on modélise le bassin sédimentaire en déterminant au moins ledit champ de déplacement et ledit champ des contraintes pour ladite représentation maillée, au moyen de ladite simulation numérique de bassin et au moins de ladite rigidité et desdites forces nodales déterminées pour ladite représentation maillée.

Selon une mise en oeuvre de l'invention, on peut subdiviser chacune desdites mailles hexaédriques de ladite représentation maillée en huit sous-mailles hexaédriques, ladite subdivision d'une desdites mailles étant réalisée de manière à ce que chaque face de ladite maille soit constituée par quatre faces de quatre sous-mailles parmi lesdites huit sous-mailles.

Selon une mise en oeuvre de l'invention, on peut, à l'étape b), déterminer ledit domaine de lissage relatif à une desdites faces appartenant à au moins une desdites sous-mailles en connectant chaque noeud de ladite face avec au moins un point placé au barycentre de la ou des sous-mailles auxquelles appartient ladite face.

Selon une mise en oeuvre de l'invention, ladite relation entre déformations et déplacements peut être une matrice de transformation reliant un vecteur des déplacements à un vecteur des déformations selon une formule s'écrivant:

$$B = [\, B_1 B_2 \ldots B_{n-1} B_n \,]$$

avec

$$B_i = \frac{1}{A_k^S} \int_{\partial \Omega_k^S} n N_i \, d\Gamma$$

où $B_i$ est une matrice associée respectivement au noeud i, avec i=1..n, de ladite ou desdites sous-mailles auxquelles appartient ledit domaine de lissage $\Omega_k^S$, $A_k^S$ est le volume dudit domaine de lissage $\Omega_k^S$, $\partial \Omega_k^S$ est une frontière dudit domaine de lissage, n est une normale sortante dudit domaine de lissage $\Omega_k^S$ et $N_i$ est une fonction de forme associée au noeud i.

Selon une mise en oeuvre de l'invention, ladite relation de passage pour un domaine de lissage relatif à une desdites faces d'au moins une desdites sous-mailles peut être une matrice de passage déterminée en fonction au moins des matrices de fonctions de forme de l'élément fini affecté à ladite ou les dites sous-mailles auxquelles appartient ledit domaine de lissage, lesdites matrices des fonctions de forme étant évaluées en chacun des noeuds de ladite ou desdites sous-mailles auxquelles appartient ledit domaine de lissage.

Selon une mise en oeuvre de l'invention, ladite rigidité et lesdites forces nodales pour chacun desdits domaines de lissage peuvent prendre la forme respectivement d'une matrice de rigidité et d'un vecteur des forces nodales, et ladite matrice de rigidité $K_{\Omega virt}$ et ledit vecteur des forces nodales $f_{\Omega virt}$ pour un desdits domaines de lissage $\Omega_{virt}$ peuvent être déterminés respectivement selon des formules s'écrivant:

$$K_{\Omega_{virt}} = \int_{\Omega_{virt}} T_{\Omega_{virt}}^T B_{\Omega_{virt}}^T D B_{\Omega_{virt}} T_{\Omega_{virt}} dV$$

$$f_{\Omega_{virt}} = -\int_{\Omega_{virt}} N^T b \, dV - \int_{\partial \Omega_{virt}} N^T \bar{t} \, dA - \int_{\Omega_{virt}} T_{\Omega_{virt}}^T B_{\Omega_{virt}}^T D \varepsilon_0 \, dV + \int_{\Omega_{virt}} T_{\Omega_{virt}}^T B_{\Omega_{virt}}^T \sigma_0 \, dV$$

dans lesquelles $T_{\Omega virt}$ est ladite matrice de passage pour ledit domaine de lissage $\Omega_{virt}$, $B_{\Omega virt}$ est ladite matrice de transformation pour ledit domaine de lissage $\Omega_{virt}$, N est une matrice desdites fonctions de forme, D est une matrice représentative de la rigidité du matériau, b est un vecteur des forces volumiques, t est un vecteur des forces surfaciques, $\varepsilon_0$ est une déformation initiale et $\sigma_0$ une contrainte résiduelle initiale.

Selon une mise en oeuvre de l'invention, on peut, à l'étape f) et si l'ensemble desdites mailles de ladite représentation maillée sont hexaédriques, déterminer ladite rigidité et lesdites forces nodales relatives à ladite représentation maillée selon des formules respectives s'écrivant

$$K = \sum_{i=1}^{nv} K_{\Omega_{virt\,i}}$$

$$f = \sum_{i=1}^{nv} f_{\Omega_{virt\,i}}$$

où nv est le nombre total desdits domaines de lissage.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre de l'étape B) du procédé tel que décrit ci-dessus, lorsque ledit programme est exécuté sur un ordinateur.

L'invention concerne également un procédé pour exploiter des hydrocarbures présents dans un bassin sédimentaire, ledit procédé comprenant au moins 1a mise en oeuvre du procédé de modélisation dudit bassin tel que décrit ci-dessus, et dans lequel, à partir au moins de ladite modélisation dudit bassin sédimentaire, on détermine un schéma d'exploitation dudit bassin comprenant au moins une implantation d'au moins un puits injecteur et/ou d'au moins un puits producteur, et on exploite lesdits hydrocarbures dudit bassin au moins en forant lesdits puits de ladite implantation et en les équipant d'infrastructures d'exploitation.

D'autres caractéristiques et avantages du procédé selon l'invention, apparaîtront à la lecture de la description ci-après d'exemples non limitatifs de réalisations, en se référant aux figures annexées et décrites ci-après.

**Liste des figures**

La figure 1 présente de manière illustrative un bassin sédimentaire.

La Figure 2 montre un exemple de bassin sédimentaire (à gauche) et un exemple de représentation maillée (à droite) de ce bassin.

La Figure 3 montre un exemple de reconstruction structurale d'un bassin sédimentaire selon un mode de réalisation de l'invention, représenté par trois états de déformations pris à trois états géologiques différents.

La Figure 4 présente la déformation d'une poutre soumise à une flexion calculée par la méthode FEM et par la méthode FS-FEM, dans le cas de mailles hexaédriques aplaties.

La Figure 5 présente un exemple de mise en oeuvre de subdivision d'une maille hexaédriques en huit sous-mailles hexaédriques.

La figure 6 illustre la construction d'un domaine de lissage selon l'invention pour une face appartenant à deux sous-mailles.

**Description des modes de réalisation**

Selon un premier aspect, l'invention concerne un procédé mis en oeuvre par ordinateur de modélisation d'un bassin sédimentaire, au moyen au moins d'une simulation numérique de bassin résolvant au moins une équation d'équilibre de la poromécanique selon une méthode aux éléments finis lissée basée sur les faces, encore connue sous l'acronyme FS-FEM ("Face-based Smoothed Finite Elément Method").

De manière générale, l'équation d'équilibre de la poromécanique s'écrit (cf. par exemple le document (Coussy, 1991)):

$$\nabla \cdot \underline{\underline{\sigma}}' + (\rho + m)\underline{g} = \nabla \cdot (p\underline{\underline{B}})$$

où $\underline{\underline{\sigma}}'$ est le tenseur de la contrainte effective, $\rho$ la densité homogénéisée du milieux poreux, $m$ l'échange de masse fluide, $\underline{g}$ l'accélération de gravité, $p$ la pression fluide et $\underline{\underline{B}}$ le tenseur de Biot. Dans une simulation numérique telle qu'une simulation de bassin, cette équation est résolue numériquement. De manière générale, cette équation est généralement discrétisée sur une représentation maillée (ou maillage) à l'aide de la méthode aux éléments finis (FEM, pour "Finite Elément Method") ou de l'une de ses variantes, comme par exemple la méthode aux éléments finis lissée (S-FEM, pour "Smoothed Finite Elément Method").

Différentes déclinaisons de la méthode S-FEM existent dans la littérature du domaine de la simulation mécanique, chacune avec ses propriétés de convergence et précision. La déclinaison dite FS-FEM (pour "Face-based Smoothed Finite Elément Method"), ou méthode aux éléments finis lissée basée sur les faces, est connue comme étant la déclinaison de la méthode S-FEM la plus précise. Toutefois, dans la littérature, la méthode FS-FEM est décrite à ce jour uniquement pour des mailles tétraédriques, et tous les cas d'application qu'on retrouve dans la littérature du domaine de la simulation mécanique utilisent un maillage tétraédrique uniquement.

La demanderesse a constaté que la méthode FS-FEM est en pratique instable dans le cas d'un maillage comprenant des mailles hexaédriques très aplaties. Ainsi, il s'avère que la méthode FS-FEM ne peut être appliquée en l'état dans le cas de modèles de bassin dont la représentation maillée comportent des mailles représentatives de couches géologiques de faibles épaisseurs (par exemple de l'ordre de quelques mètres dans la direction verticale) et/ou lorsque ces couches présentent des biseaux stratigraphiques (par exemple caractérisés par un angle inférieur à 1°).

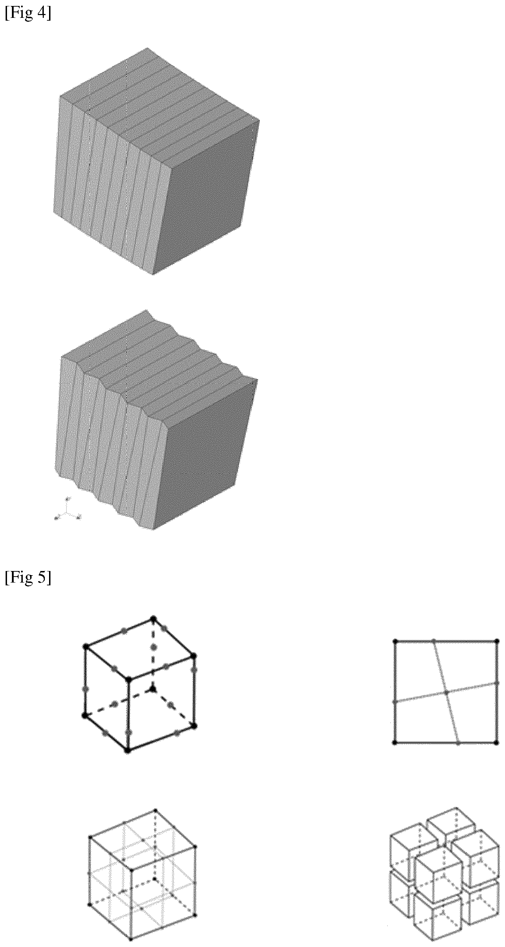

L'instabilité de la méthode FS-FEM en présence de mailles hexaédriques aplaties (c'est-à-dire dont le rapport de la plus grand arête horizontale sur la plus petite arête verticale vaut au moins 5, préférentiellement 10) se concrétise de deux façons différentes dans les simulations numériques : soit le calcul s'arrête avec une erreur fatale car la matrice de rigidité du modèle est singulière (déterminant nul), ce qui signifie qu'elle ne peut pas être inversée, soit la solution calculée est erronée et présente localement des oscillations et/ou des pics dans les déplacements, contraintes et déformations calculés. Un exemple de ce dernier cas est présenté en figure 4, dans le cadre d'une poutre soumise à une flexion, la poutre étant représentée au moyen de mailles constituées par des hexaèdres aplatis (rapport de forme de 1 sur 10). Plus précisément, la figure 4 haut présente la géométrie de la poutre déformée calculée avec la méthode FEM. Cette déformée est correcte car cohérente avec la solution analytique connue du problème. La figure 4 bas présente la géométrie de la poutre déformée obtenue avec la méthode FS-FEM : la déformation est clairement incorrecte et la forme en accordéon est le signe typique de l'instabilité numérique (voir aussi le paragraphe 4.6 du document (Cook, 1995).

La présente invention concerne un perfectionnement de la méthode FS-FEM, de manière à la rendre applicable aux mailles hexaédriques utilisées dans les modèles de bassin. En particulier, de manière particulièrement astucieuse, la demanderesse a montré que le perfectionnement de la méthode FS-FEM selon l'invention permet de stabiliser la simulation numérique, y compris dans le cas de mailles hexaédriques aplaties.

Ainsi, la simulation numérique de bassin selon l'invention vise à résoudre numériquement au moins l'équation d'équilibre de la poromécanique selon la méthode aux éléments finis lissée basée sur les faces (FS-FEM), et ce, dans le cas d'une représentation maillée de type hexa-dominant.

De manière générale, la discrétisation de l'équation d'équilibre de la poromécanique conduit à l'écriture d'un système d'équations algébriques qui a la forme suivante (cf. par exemple l'équation 2.23 du document (Zienkiewicz and Taylor, 2000)) :

$$\mathbf{Ka} + \mathbf{f} = \mathbf{r} \qquad (1)$$

où K est la matrice de rigidité du système ("*stiffness matrix*"), a est le vecteur des degrés de liberté des noeuds du maillage utilisé pour la discrétisation ("*nodal displacements*", cf. équation *2.1* du document (Zienkiewicz and Taylor, 2000)), f est un vecteur des forces nodales ("équivalent nodal forces ", cf équation 2.24b dans le document (Zienkiewicz and Taylor, 2000)) et r est le vecteur des forces externes ponctuelles ("*external concentrated forces*", *cf. équation 2.14* du document (Zienkiewicz and Taylor, 2000)). Les détails de la résolution de ce système d'équations par une méthode des éléments finis lissée basée sur les faces spécifiquement adaptée au cas de mailles hexaédriques sont donnés dans l'étape 2 du procédé selon l'invention.

Selon l'invention, on considère que le bassin sédimentaire a subi une pluralité d'événements géologiques définissant une séquence d'états du bassin, chacun desdits états s'étendant entre deux événements géologiques successifs. De manière préférée, la séquence d'états peut couvrir une période de temps couvrant au moins la production d'hydrocarbures, notamment par maturation d'une matière organique présente dans une roche-mère du bassin, la déformation du bassin due à des contraintes mécaniques 3D, le déplacement de ces hydrocarbures produits vers au moins une roche réservoir du bassin au cours des temps géologiques. Par la suite et de manière non limitative, on note Ai un état de la séquence d'états du bassin, i étant un entier variant de 1 à n, An représentant l'état du bassin au temps actuel. Selon l'invention, n vaut au moins 2. Autrement dit, la séquence d'états selon l'invention comprend l'état du bassin au temps actuel et au moins un état dudit bassin à un temps géologique antérieur.

Selon un deuxième aspect, l'invention concerne un procédé pour exploiter des hydrocarbures présents dans un bassin sédimentaire, le procédé selon le deuxième aspect comprenant la mise en oeuvre du procédé de modélisation d'un bassin sédimentaire selon le premier aspect de l'invention.

Le procédé selon le premier aspect de l'invention comprend au moins les étapes 1) et 2) décrites ci-après.

Le procédé selon le deuxième aspect de l'invention comprend au moins les étapes 1) à 3) décrites ci-après.

## 1) Construction de représentations maillées pour chacun des états

Au cours de cette étape, on réalise des mesures de grandeurs physiques relatives au bassin au moyen de capteurs, on construit une représentation maillée représentative du bassin au temps actuel puis des représentations maillées pour chacun des états du bassin. Selon l'invention, les représentations maillées du bassin pour chacun desdits états sont majoritairement formées par des mailles hexaédriques. On parle classiquement de maillage hexa-dominant.

Au cours de cette étape, on applique au moins les trois sous-étapes suivantes :

## 1.1) Mesures de grandeurs physiques relatives au bassin

Au cours de cette sous-étape, il s'agit d'acquérir des mesures de grandeurs physiques relatives au bassin étudié, au moyen de capteurs.

De manière non limitative, les capteurs peuvent consister en des outils de mesures diagraphiques, en des sources et récepteurs sismiques, en des préleveurs et analyseurs de fluide, etc.

Ainsi, les mesures selon l'invention peuvent consister en des études d'affleurement, des campagnes d'acquisition sismique, des mesures dans des puits (par diagraphies par exemple), des analyses pétrophysiques et/ou géochimiques de carottes prélevées in situ.

A partir de ces mesures, on peut en déduire des propriétés pétrophysiques associées au bassin étudié, tels que le faciès (lithologie), la porosité, la perméabilité, ou encore la teneur en matière organique en des points de mesure du bassin. On peut aussi obtenir des informations sur les propriétés des fluides présents dans le bassin, telles que des valeurs de saturation des différents fluides présents dans le bassin. Egalement, on peut mesurer des températures en différents points du bassin (températures de fond de puit notamment).

**1.2) Construction d'une représentation maillée représentative du bassin à l'état actuel**

Au cours de cette sous-étape, il s'agit de construire une représentation maillée hexadominante représentative du bassin à l'état actuel, à partir des mesures des grandeurs physiques réalisées à la sous-étape précédente.

Plus précisément, la construction d'une représentation maillée d'un bassin consiste à discrétiser en trois dimensions l'architecture du bassin, à attribuer des propriétés à chacune des mailles de cette représentation maillée. Pour ce faire, on exploite notamment les mesures des grandeurs physiques réalisées en différents points du bassin telles que décrites ci-dessus, que l'on extrapole et/ou interpole, en les différentes mailles de la représentation maillée, suivant des hypothèses plus ou moins restrictives.

Le plus souvent la discrétisation spatiale d'un bassin sédimentaire est organisée en couches de mailles, représentant chacune les différentes couches géologiques du bassin étudié. La Figure 2 illustre à gauche un exemple de bassin sédimentaire au temps actuel, et à droite un exemple de représentation maillée de ce bassin.

Selon une mise en oeuvre de l'invention, la représentation maillée pour l'état actuel An du bassin donné comprend notamment en chaque maille une information sur la lithologie, une valeur de porosité, une valeur de perméabilité, une teneur en matière organique, ainsi que des propriétés relatives aux fluides présents dans la maille, telles que la saturation.

Selon une mise en oeuvre de l'invention, la représentation maillée pour l'état actuel An du bassin est majoritairement formées par des mailles hexaédriques. On peut pour ce faire utiliser le logiciel OPENFLOW® (IFP Énergies nouvelles, France) ou encore le logiciel GOCAD® (Emerson-Paradigm, USA).

**1.3) Reconstruction structurale de l'architecture du bassin pour les différents états**

Au cours de cette sous-étape, il s'agit de reconstruire les architectures passées du bassin pour les différents états Ai, avec i variant de 1 à n-1. Pour ce faire, on déforme la représentation maillée construite à la sous-étape précédente, qui représente le bassin au temps actuel, afin de représenter l'évolution anti-chronologique de l'architecture du sous-sol au cours des temps géologiques, et ce pour les différents états Ai. A l'issue de cette sous-étape, on dispose d'une représentation maillée pour chaque état Ai, avec i variant de 1 à n.

Selon un premier mode de réalisation de la présente invention, la reconstruction structurale peut être particulièrement simple si elle se base sur l'hypothèse que sa déformation résulte uniquement d'une combinaison de mouvements verticaux par compaction du sédiment ou par surrection ou affaissement de son socle. Cette technique, connue sous le terme de "backstripping" (ou "décompaction progressive du bassin" en français) est décrite par exemple dans (Steckler et Watts, 1978).

Selon un autre mode de réalisation de la présente invention, dans le cas de bassins dont l'histoire tectonique est complexe, notamment dans le cas de bassins présentant des failles, il convient d'utiliser des techniques aux hypothèses moins restrictives, telles que la restauration structurale. Une telle restauration structurale est décrite par exemple dans le document FR 2930350 A1 (US 2009/0265152 A1). La restauration structurale consiste à calculer les déformations successives que le bassin a subies, en intégrant les déformations dues à la compaction et celles qui résultent des forces tectoniques.

Dans l'exemple de la Figure 3, trois états sont utilisés pour représenter la déformation du sous-sol au cours des temps géologiques. La représentation maillée de gauche représente l'état actuel, où l'on peut observer une interface de glissement (ici une faille). La représentation maillée de droite représente le même bassin sédimentaire pour un état Ai, antérieur à l'état actuel. Pour cet état Ai, les couches sédimentaires n'étaient pas encore fracturées. La représentation maillée centrale est un état intermédiaire, c'est-à-dire qu'elle représente le bassin sédimentaire à un état Ai', compris entre l'état Ai et l'état actuel. On constate que le glissement le long de la faille a commencé à modifier l'architecture du bassin.

**2) Détermination d'un champ de déformation et de contrainte par simulation numérique de bassin pour chacun des états**

Au cours de cette étape, au moyen de la simulation numérique de bassin et des représentations maillées déterminées pour chacun des états à l'étape précédente, on détermine au moins un champ de déformation et un champ de contrainte pour chacun des états, en appliquant au moins les sous-étapes 2.1 à 2.5 et les sous-étapes 2.7 à 2.8 décrites ci-après pour chacun des états. Autrement dit, au moins les sous-étapes 2.1 à 2.5 et les sous-étapes 2.7 à 2.8 décrites ci-après sont appliquées pour chaque représentation maillée représentative d'un état du bassin étudié.

Selon l'invention, les sous-étapes 2.1 à 2.5 sont uniquement appliquées aux mailles hexaédriques des représentations maillées de chacun des états. Selon une mise en oeuvre de l'invention, dans le cas où la représentation maillée d'un quelconque état comprend à la fois des mailles hexaédriques et des mailles d'un autre type, on peut appliquer la sous-étape 2.6 aux mailles d'un autre type que le type hexaédrique. Selon l'invention, les sous-étapes 2.7 et 2.8 sont applicables quel que soit le type de maille de la représentation maillée d'un état.

**2.1) Subdivision des mailles hexaédriques de la représentation**

Au cours de cette sous-étape, on subdivise chacune des mailles hexaédriques (appelées aussi "mailles parentes" par la suite) de la représentation maillée considérée en au moins huit sous-mailles hexaédriques (appelées aussi "mailles virtuelles" par la suite). Il est bien clair que les mailles non hexaédriques de la représentation maillée considérée ne font pas l'objet d'une subdivision telle que décrite dans cette sous-étape. Le traitement d'autres types de mailles de la représentation maillée que le type hexaédrique est détaillé ci-après dans la sous-étape 2.6.
Selon une mise en oeuvre préférée de l'invention, on peut subdiviser chacune des mailles hexaédriques de la représentation maillée en huit sous-mailles hexaédriques, la subdivision étant réalisée de manière à ce que chaque face de la maille parente soit constituée par quatre faces de quatre sous-mailles parmi les huit sous-mailles.
Selon cette mise en oeuvre préférée de l'invention, on peut procéder à la subdivision d'une maille hexaédrique en huit sous-mailles hexaédriques de la manière suivante :

-   on divise chaque arête de la maille parente en deux arêtes de longueur quelconque. Par la suite, on appelle « noeud virtuel » le point en commun entre les deux arêtes ainsi formées et « noeud réel » l'autre extrémité de chaque arête, qui coïncide avec un des coins (noeud réel) de la maille parent. Un exemple illustratif de subdivision d'arêtes d'une maille hexaédrique est montré sur la figure 5 en haut à gauche, dans laquelle un point en noir représente un noeud réel, et un point en gris représente un noeud virtuel.

-   on subdivise chaque face de la maille parent en quadrangles, à partir des noeuds virtuels créés par subdivision des arêtes et en ajoutant un noeud virtuel supplémentaire à l'intérieur de la face considérée (ou autrement dit pas sur une arête). Un exemple illustratif de subdivision d'une face d'une maille hexaédrique en quadrangles est montré sur la figure 5 en haut à droite, dans laquelle un quadrangle est formé par une partie (entre un noeud réel est un noeud virtuel) de deux arêtes de la maille parente, et par deux arêtes (représentées par un trait en gris pointillé entre deux noeuds virtuels), un de ces noeuds virtuels étant placé à l'intérieur de la face.

-   à partir des quadrangles ainsi créés et en ajoutant un noeud virtuel supplémentaire à l'intérieur de la maille (ou autrement dit pas sur une face), à partir d'un quadrangle donné (appelé aussi face de base), on construit une sous-maille (ou maille virtuelle) en s'appuyant sur le quadrangle sélectionné, sur les quadrangles adjacents qui ne sont pas coplanaires à la face de base et sur les faces de trois autres sous-mailles (ou mailles virtuelles). Un exemple illustratif de construction de sous-mailles est montré sur la figure 5 en bas à gauche. Les sous-mailles ainsi créées s'appuient donc à la fois sur des noeuds réels et virtuels. On peut observer que chaque face de la maille parente est constituée par quatre faces de quatre sous-mailles.

La figure 5 en bas à droite présente le résultat final de la subdivision d'une maille parente en huit sous-mailles (ou mailles virtuelles) selon ce mode préférée de mise en oeuvre de l'invention. Les sous-mailles sont ici représentées de manière disjointes en vue d'améliorer la clarté de la figure, mais il est bien clair que deux sous-mailles voisines partagent une même face.
Cette sous-étape est répétée pour chaque maille héxaédrique de la représentation maillée d'un état.

**2.2) Détermination d'un domaine de lissage virtuel pour chaque face de chaque sous-maille**

Au cours de cette sous-étape, pour chacune des faces de chacune des sous-mailles telles que déterminées à la sous-étape précédente, on détermine un domaine de lissage selon la méthode des éléments finis lissée basée sur les faces appliquée aux sous-mailles. Par la suite, on appelle ces domaines « domaines de lissage virtuels » (et notés $\Omega$virt) car construits à partir des mailles virtuelles uniquement. Par "appliquée aux sous-mailles", on entend que la méthode des éléments finis lissée basée sur les faces est appliquée telle que décrite de manière générale dans la littérature, mais en considérant les sous-mailles hexaédriques telles que déterminées ci-dessus, alors que la méthode des éléments finis lissée est décrite habituellement pour une application à des mailles. La différence entre une sous-maille et une maille n'est pas géométrique : les deux sont des mailles hexaédriques mais les noeuds qui définissent une sous-maille comprennent à la fois des noeuds virtuels et réels, alors que ceux qui définissent une maille sont des noeuds réels uniquement. La différence entre un noeud réel et un noeud virtuel est que les degrés de liberté du problème (vecteur a dans l'équation (1) ci-dessus) sont associés aux noeuds réels uniquement. Aucun degré de liberté n'étant associé à un noeud virtuel, les domaines de lissage virtuels selon l'invention demandent un traitement additionnel par rapport à ce qui est fait pour un domaine de lissage d'une maille réelle (maille parente dans le cas d'espèce), et donc par rapport à ce qui est décrit dans la littérature pour la méthode des éléments finis lissée. Ce traitement additionnel est décrit à la sous-étape 2.4 ci-après.

De manière générale, la méthode des éléments finis lissée basée sur les faces (méthode FS-FEM), et plus généralement la méthode des éléments finis lissée (méthode S-FEM), utilisent, dans la formulation de l'équilibre mécanique, une déformation lissée calculée par une moyenne pondérée de la déformation selon une équation du type (cf.

$$\overline{\boldsymbol{\varepsilon}}(\mathbf{x}_k) = \frac{1}{A_k^s} \int_{\Omega_k^s} \tilde{\boldsymbol{\varepsilon}}(\mathbf{x}) \, d\Omega$$

par exemple l'équation 4.19 du document (Liu and Nguyen Thoi Trung, 2010)) , (2) où $\overline{\varepsilon}$ est la déformation lissée de la méthode S-FEM ou de la méthode FS-FEM, $\varepsilon$ est la déformation (utilisée par la méthode FEM) et $A_k^S$ est le volume d'un domaine de lissage $\Omega_k^S$ sur lequel la déformation est lissée.

Selon ces méthodes, dont on trouve une description dans le document (Liu and Nguyen Thoi Trung, 2010), l'équation (2) ci-dessus est calculée sur chaque domaine de lissage $\Omega_k^S$. Les domaines de lissage pour la méthode S-FEM, la méthode FS-FEM ou encore les domaines de lissage selon l'invention sont déterminés de telle manière que :

- les domaines de lissage couvrent entièrement le maillage ;

- il n'y a pas de recouvrement entre les domaines.

Selon une mise en oeuvre de l'invention, on construit au moins un domaine de lissage associé à une face appartenant à une ou à deux sous-mailles en connectant chaque noeud (réel ou virtuel) de la face considérée avec au moins un point placé au barycentre de la ou des sous-mailles auxquelles appartient la face.

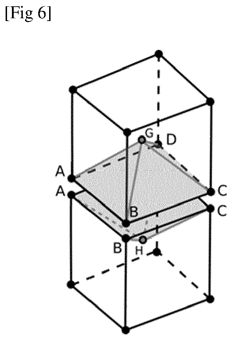

La figure 6 illustre la construction d'un tel domaine de lissage pour une face appartenant à deux sous-mailles. Ainsi, le domaine de lissage associé à la face ABCD, qui est commune à deux sous-mailles, est construit en connectant chaque noeud A, B, C, D de la face avec le barycentre G et I de chaque sous-maille. Le domaine de lissage en résultant, montré en grisé sur cette figure, est composé par deux pyramides ABCDG et ABCDH.

Il est bien clair que pour une face d'une sous-maille hexaédrique située sur les bords d'une représentation maillée, c'est-à-dire une face n'appartenant qu'à une seule sous-maille (autrement dit une face libre), le domaine de lissage est composé d'une seule pyramide, car les noeuds d'une face ne peuvent être reliés qu'à un seul barycentre.

### 2.3) Détermination d'une relation entre déformations et déplacements pour chaque domaine de lissage virtuel

Au cours de cette étape, pour chacun des domaines de lissage virtuels tels que déterminés à la sous-étape précédente, on détermine une relation entre déformations et déplacements selon la méthode des éléments finis lissée basée sur les faces appliquée aux domaines de lissage virtuels tels que déterminés ci-dessus. Par "appliquée aux domaines de lissage" , on entend que la méthode des éléments finis lissée basée sur les faces est appliquée telle que décrite de manière générale dans la littérature, mais en considérant les domaines de lissage tels que déterminés ci-dessus, c'est-à-dire pour des sous-mailles hexaédriques.

Selon une mise en oeuvre de l'invention, ladite relation entre déformation et déplacement prend la forme d'une matrice reliant le vecteur des déplacements à un vecteur des déformations. Cette matrice est aussi appelée matrice de transformation des déplacements en déformations ("strain-displacement transformation").

Selon une mise en oeuvre de l'invention, l'utilisation de l'équation (2) ci-dessus pour la définition de la déformation lissée conduit à l'expression suivante pour la matrice de transformation des déplacements en déformations, notée B (cf. aussi les équations 4.29, 4.30 et 4.31 du document (Liu and Nguyen Thoi Trung, 2010)):

$$B = [B_1 B_2 \dots B_{n-1} B_n] \ (3)$$

avec

$$B_i = \frac{1}{A_k^S} \int_{\partial \Omega_k^S} n N_i \, d\Gamma \ (4)$$

où $B_1 \dots B_n$ sont les matrices associées respectivement aux noeuds i=1..n de la ou des sous-mailles auxquelles appartient le domaine de lissage $\Omega_k^S$, $A_k^S$ est le volume du domaine de lissage $\Omega_k^S$, $\partial\Omega_k^S$ est la frontière du domaine de lissage, n est la normale sortante du domaine de lissage $\Omega_k^S$ et $N_i$ est la fonction de forme ("shape function" ; cf. paragraphe 2.2.1 du document (Zienkiewicz and Taylor, 2000)) associée au noeud i.

**2.4) Détermination d'une relation de passage entre les degrés de liberté des nœuds des sous-mailles et des nœuds des mailles pour chaque domaine de lissage virtuel**

Au cours de cette sous-étape, qui est appliquée pour chacun des domaines de lissage déterminés tel que décrit ci-dessus, on détermine une relation de passage entre les degrés de liberté des noeuds (situés aux extrémités des arêtes des sous-mailles), réels ou virtuels, de la ou des sous-mailles qui contiennent le domaine de lissage considéré et les degrés de liberté des noeuds de la ou des mailles (parentes) auxquelles appartiennent la ou les sous-mailles considérées.

Selon une mise en oeuvre de l'invention, ladite relation de passage peut prendre la forme d'une matrice de transformation ou encore une matrice de passage. Selon cette mise en oeuvre de l'invention, cette matrice de passage permet d'exprimer les degrés de liberté des noeuds (réels ou virtuels) des mailles virtuelles par rapport aux degrés de liberté des noeuds réels des mailles parent du maillage.

Selon une mise en oeuvre de l'invention, la matrice de passage relative à un domaine de lissage est déterminée en fonction au moins de matrices de fonctions de forme de l'élément fini affecté à la ou les mailles auxquelles appartient ledit domaine de lissage, les matrices de fonctions de forme étant évaluées en chacun des noeuds de la ou des sous-mailles auxquelles appartient ledit domaine de lissage.

Selon une mise en oeuvre de l'invention, on réalise cette sous-étape pour un domaine de lissage virtuel $\Omega_{\text{virt}}$ de la manière suivante :

a) on détermine la ou les sous-mailles *i* qui contiennent le domaine de lissage considéré. Si la face sur laquelle a été généré le domaine de lissage considéré est une face libre (c'est-à-dire si la face est située sur le bord de la représentation maillée), le domaine de lissage n'est contenu que dans une seule sous-maille (et on note i=1 par la suite). Si la face est commune à deux sous-mailles, le domaine de lissage est contenu dans deux sous-mailles (et on note i=1,2 par la suite).

b) Pour chaque sous-maille *i* (i=1 ou i =1,2) ainsi identifiée, on calcule une matrice de passage $T_i$ à l'aide des fonctions de forme N de la maille parent qui contient la sous-maille considérée selon une formule du type (cf. *eq. 2.1* du document (Zienkiewicz and Taylor, 2000)) :

$$T_i = \begin{bmatrix} N_i(x_1) \\ ... \\ N_i(x_n) \end{bmatrix} \tag{5}$$

où $N_i(x_j)$ est la matrice des fonctions de forme ("shape functions" ; cf. paragraphe 2.2.1 du document (Zienkiewicz and Taylor, 2000)) de l'élément fini affecté à la maille parent qui contient la sous-maille i (i=1 ou i =1,2) évaluée au noeud *j* de la sous-maille *i*, avec *j=1..n,* et *n* étant le nombre des noeuds (réels et virtuels) de la sous-maille i.

c) Dans le cas d'une face libre (i=1), la matrice de passage $T_{\Omega\text{virt}}$ relative au domaine de lissage virtuel $\Omega_{\text{virt}}$ est égale à la matrice $T_i$ telle que déterminée ci-dessus ; sinon, on construit la matrice de passage $T_{\Omega\text{virt}}$ relative au domaine de lissage virtuel $\Omega_{\text{virt}}$ à l'aide des deux matrices $T_i$ calculées au point précédent selon une formule du type :

$$T_{\Omega_{virt}} = \begin{bmatrix} T_1 \\ T_2 \end{bmatrix} \tag{6}$$

**2.5) Détermination d'une rigidité et des forces nodales pour chacun des domaines de lissage virtuels**

Au cours de cette sous-étape, on détermine une rigidité et des forces nodales pour chacun des domaines de lissage déterminés tel que décrit ci-dessus, à partir au moins de la relation de passage déterminée pour le domaine de lissage considéré tel que décrit ci-dessus et de la relation entre déformations et déplacements déterminée pour ce même domaine de lissage tel que décrit ci-dessus.

Selon une mise en oeuvre de l'invention, ladite rigidité et lesdites forces nodales peuvent prendre la forme respectivement d'une matrice de rigidité et d'un vecteur de forces nodales.

Selon une mise en oeuvre de l'invention, on détermine la matrice de rigidité $K_{\Omega virt}$ et le vecteur des forces nodales $\mathbf{f}_{\Omega virt}$ pour un domaine de lissage virtuel $\Omega_{virt}$ de la manière suivante :

$$K_{\Omega_{virt}} = \int_{\Omega_{virt}} T_{\Omega_{virt}}^T B_{\Omega_{virt}}^T DB_{\Omega_{virt}} T_{\Omega_{virt}} dV \qquad (7)$$

$$f_{\Omega_{virt}} =-$$

$$\int_{\Omega_{virt}} N^T b dV - \int_{\partial\Omega_{virt}} N^T \bar{t} dA - \int_{\Omega_{virt}} T_{\Omega_{virt}}^T B_{\Omega_{virt}}^T D\varepsilon_0 dV + \int_{\Omega_{virt}} T_{\Omega_{virt}}^T B_{\Omega_{virt}}^T \sigma_0 dV$$

$$(8)$$

dans lesquelles la matrice de transformation $T\Omega_{virt}$ est la matrice de passage déterminée tel que décrit à la sous-étape 2.4, $B\Omega_{virt}$ est une matrice de transformation déformation-déplacement déterminée tel que décrit à la sous-étape 2.3, N est la matrice des fonctions de forme de l'élément fini de la maille parent décrit ci-dessus, D est une matrice représentative de la rigidité du matériau, b est le vecteur des forces volumiques ("body forces"), $\bar{t}$ le vecteur des forces surfaciques ("distributed external loading"), $\varepsilon_0$ la déformation initiale ("initial strains"; cf. paragraphe 2.2.3 du document (Zienkiewicz and Taylor, 2000)) et $\sigma_0$ la contrainte résiduelle initiale ("initial residual stresses" ; cf. paragraphe 2.2.3 du document (Zienkiewicz and Taylor, 2000)).

**2.6) Détermination d'une rigidité et des forces nodales pour les mailles non hexaédriques**

Cette sous-étape est optionnelle et peut être appliquée dans le cas où la représentation maillée de l'état du bassin considéré est un maillage hexa-dominant, comprenant majoritairement des mailles hexaédriques mais comprenant aussi en minorité d'autres types de mailles (tels que des mailles tétraédriques, pyramidales, pentaédriques, etc).

Dans ce cas, on peut appliquer la méthode des éléments finis lissée basée sur les faces telle que décrite dans le document (Liu and Nguyen Thoi Trung, 2010) aux autres types de maille de la représentation maillée. L'application de cette méthode aux autres types de maille conduit à définir des domaines de lissage pour chacune des faces de ces mailles (sans subdivision de ces mailles) et à déterminer une matrice de rigidité (que l'on note $K_\Omega$ par la suite) et un vecteur des forces nodales (que l'on note $f_\Omega$ par la suite) pour chaque domaine de lissage relatif à chacune des faces des autres types de maille de la représentation maillée.

Selon une mise en oeuvre de l'invention, un domaine de lissage pour une face appartenant à une ou à deux mailles d'un autre type que le type hexaédrique peut être construit en connectant chaque noeud de la face considérée avec au moins un point supplémentaire placé au barycentre de la ou des mailles auxquelles appartient la face.

Selon une mise en oeuvre de l'invention, lorsqu'une face est commune entre une sous-maille hexaédrique et une maille d'un autre type, on considère cette face comme une face libre pour la construction des domaines de lissage. Autrement dit, pour une telle face, on construit deux domaines de lissage, un premier du côté de la sous-maille hexaédrique et un deuxième du côté de la maille d'un autre type, chaque domaine de lissage étant construit en connectant chacun des noeuds de la face considérée au barycentre de la maille à laquelle le noeud appartient.

Selon une mise en oeuvre de l'invention, la matrice de rigidité $K_\Omega$ et le vecteur des forces nodales $f_\Omega$ relatifs à un domaine de lissage construit pour des mailles non hexaédriques peuvent être déterminés au moyen des équations 2.24a, 2.24b du document (Zienkiewicz and Taylor, 2000), et en utilisant la définition de la matrice de transformation des déplacements en déformations, notée B décrite dans l'équation 3.67 du document (Liu and Nguyen Thoi Trung, 2010).

**2.7) Détermination d'une rigidité et des forces nodales pour la représentation maillée**

Au cours de cette sous-étape, on détermine une rigidité et des forces nodales relatives à la représentation maillée de l'état considéré à partir au moins de la rigidité et des forces nodales déterminées pour chacun des domaines de lissage virtuels définis tel que décrit ci-dessus pour cette représentation maillée.

Selon une mise en oeuvre de l'invention dans laquelle la rigidité et/ou les forces nodales peuvent prendre la forme respectivement d'une matrice de rigidité et d'un vecteur des forces nodales, on assemble les matrices de rigidité $K_{\Omega virt}$ et les vecteurs $f_{\Omega virt}$ déterminés pour chaque domaine de lissage virtuel $\Omega_{virt}$ au cours de la sous-étape précédente au moyen d'un assemblage ("assembly" en anglais) standard utilisé dans la méthode des éléments finis (cf. paragraphe 1.3 du document (Zienkiewicz and Taylor, 2000)), et qui peut s'écrire de la manière suivante :

$$K = \sum_{i=1}^{nv} K_{\Omega_{virt\,i}} \qquad (9)$$

$$f = \sum_{i=1}^{nv} f_{\Omega_{virt\,i}} \qquad (10)$$

où nv est le nombre total de domaines de lissage virtuels $\Omega_{virt}$.

Selon une mise en oeuvre de l'invention selon laquelle la représentation maillée de l'état considéré comprend majoritairement des mailles hexaédriques et minoritairement d'autres types de maille, on détermine une matrice de rigidité et un vecteur des forces nodales pour la représentation maillée selon une formule du type :

$$\mathrm{K} = \sum_{i=1}^{nv} K_{\Omega_{virt\,i}} + \sum_{i=1}^{n} K_{\Omega_i} \qquad (11)$$

$$f = \sum_{i=1}^{nv} f_{\Omega_{virt\,i}} + \sum_{i=1}^{n} f_{\Omega_i} \qquad (12)$$

où nv est le nombre total de domaines de lissage virtuels $\Omega_{virt}$ construits pour les mailles hexaédriques, et n est le nombre total de domaines de lissage $\Omega$ construits pour les autres types de mailles tel que décrit à la sous-étape 2.6.

## 2.8) Détermination du champ de déplacement et du champ des contrainte pour la représentation maillée

Au cours de cette sous-étape, on modélise le bassin étudié en déterminant au moins le champ de déplacement et le champ de contrainte pour la représentation maillée considérée, au moyen de la simulation numérique de bassin selon l'invention et au moins de la rigidité et des forces nodales déterminées pour la représentation maillée considérée et déterminées tel que décrit à la sous-étape précédente.

Selon une mise en oeuvre de l'invention, on résout le problème discrétisé défini par l'équation (1) ci-dessus implémentée dans le simulateur de bassin selon l'invention, et mis en oeuvre avec la matrice de rigidité K déterminée tel que décrit ci-dessus (et par exemple calculée par les équations (9) ou (11) ci-dessus), et le vecteur des forces nodales f déterminé tel que décrit ci-dessus (et par exemple calculé par l'équation (10) ou (12) ci-dessus). La détermination du vecteur r de l'équation (2), qui est le vecteur des conditions aux limites, peut être réalisée selon la méthode FEM classique, et par exemple tel que décrit dans le paragraphe 1.3 du document (Zienkiewicz and Taylor, 2000).

Selon l'invention, au moins les sous-étapes 2.1 à 2.5 et les sous-étapes 2.6 et 2.7 sont répétées pour chaque représentation maillée représentative de chaque état du bassin, la sous-étape 2.6 étant également répétée dans le cas d'une représentation maillée comprenant des mailles hexaédriques mais aussi d'autres types de maille.

## 3) Exploitation des hydrocarbures du bassin

Cette étape est mise en oeuvre dans le cadre du deuxième aspect de l'invention, qui concerne un procédé pour exploiter des hydrocarbures présents dans un bassin sédimentaire.

A l'issue de la mise en oeuvre des précédentes étapes, on dispose de résultats de simulation de bassin. La simulation de bassin selon l'invention permet au moins de déterminer le champ des contraintes et des déformations du bassin pour différents états du bassin, et ce, de manière stable dans le cas d'un maillage hexa-dominant dont certaines mailles présentent un mauvais rapport de forme.

De manière implicite, et comme cela est classique en simulation de bassin, on dispose en outre de la quantité des hydrocarbures présents dans chacune des mailles de la représentation maillée du bassin pour les temps passés et au temps actuel.

En outre, en fonction du simulateur de bassin utilisé pour mettre en oeuvre l'invention, on peut disposer par exemple d'informations sur :

   i. la mise en place des couches sédimentaires,
   ii. leur compaction sous l'effet du poids des sédiments sus-jacents,
   iii. l'évolution de leur température au cours de leur enfouissement,
   iv. les modifications de pressions de fluides résultant de cet enfouissement,
   v. la formation des hydrocarbures formés par thermogénèse.

A partir de telles informations, le spécialiste peut alors déterminer des mailles de la représentation maillée du bassin au temps actuel comportant des hydrocarbures, ainsi que la teneur, la nature et la pression des hydrocarbures qui y sont piégés. On peut alors sélectionner les zones du bassin étudié présentant le meilleur potentiel pétrolier. Ces zones sont alors identifiées comme des réservoirs (ou encore des gisements d'hydrocarbures) du bassin sédimentaire étudié.

Au cours de cette étape, il s'agit de déterminer au moins un schéma d'exploitation des hydrocarbures contenus dans la bassin sédimentaire étudié. De manière générale, un schéma d'exploitation comprend un nombre, une géométrie et une implantation (position et espacement) des puits injecteurs et producteurs à forer dans le bassin. Un schéma d'exploitation peut en outre comprendre un type de récupération assistée des hydrocarbures contenus dans le ou les réservoirs du bassin, telle qu'une récupération assistée au moyen de l'injection d'une solution comprenant un ou des polymères, de la mousse de $CO_2$, etc. Un schéma d'exploitation d'un réservoir d'hydrocarbures d'un bassin doit par exemple permettre un fort taux de récupération des hydrocarbures piégés dans ce réservoir, sur une longue durée d'exploitation, et nécessitant un nombre de puits limité. Autrement dit, le spécialiste prédéfinit des critères d'évaluation selon lesquels un schéma d'exploitation des hydrocarbures présents dans un réservoir d'un bassin sédimentaire est considéré comme suffisamment performant pour être mis en oeuvre.

Selon un mode de mise en oeuvre de l'invention, on définit une pluralité de schémas d'exploitation des hydrocarbures contenus dans un ou des réservoirs géologiques du bassin étudié et on estime, à l'aide d'un simulateur de réservoir (tel que le logiciel PUMAFLOW® (IFP Energies nouvelles, France)) au moins un critère d'évaluation de ces schémas d'exploitation. Ces critères d'évaluation peuvent comprendre la quantité d'hydrocarbures produit pour chacun des différents schémas d'exploitation, la courbe représentative de l'évolution de la production dans le temps au niveau de chacun des puits envisagés, le rapport huile sur gaz (GOR) au niveau de chaque puits envisagé, etc. Le schéma selon lequel les hydrocarbures contenus dans le ou les réservoirs du bassin étudié sont réellement exploités peut alors correspondre à celui satisfaisant au moins un des critères d'évaluation des différentes schémas d'exploitation.

Puis, une fois un schéma d'exploitation déterminé, les hydrocarbures piégés dans le ou les réservoirs pétroliers du bassin sédimentaire étudié sont exploités en fonction de ce schéma d'exploitation, notamment au moins en forant les puits injecteurs et producteurs du schéma d'exploitation ainsi déterminés, et en installant les infrastructures de production nécessaires au développement de ce ou ces réservoirs. Dans le cas où le schéma d'exploitation a en outre été déterminé en estimant la production d'un réservoir associée à différents types de récupération assistée, on injecte dans le puits injecteur le ou les types d'additifs (polymères, tensio-actifs, mousse de $CO_2$) sélectionnés.

Il est bien entendu qu'un schéma d'exploitation des hydrocarbures d'un bassin peut être évolutif sur la durée de l'exploitation des hydrocarbures de ce bassin, en fonction par exemple de connaissances additionnelles relatives au bassin acquises pendant cette exploitation, des améliorations dans les différents domaines techniques intervenant lors d'une exploitation d'un gisement d'hydrocarbures (améliorations dans le domaine du forage, de la récupération assistée par exemple).

**Equipement et produit programme d'ordinateur**

Le procédé selon l'invention est mis en oeuvre au moyen d'un équipement (par exemple un poste de travail informatique) comprenant des moyens de traitement des données (un processeur) et des moyens de stockage de données (une mémoire, en particulier un disque dur), ainsi qu'une interface d'entrée et de sortie pour saisir des données et restituer les résultats du procédé.

Les moyens de traitement de données sont configurés pour réaliser en particulier l'étape 2 décrite ci-dessus.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé tel que décrit précédemment, et notamment de l'étape 2), lorsque ledit programme est exécuté sur un ordinateur.

Ainsi le procédé selon le premier aspect de l'invention permet de stabiliser une simulation numérique de bassin résolvant au moins une équation d'équilibre de la poromécanique selon une méthode aux éléments finis lissée basée sur les faces, dans le cas d'un maillage hexa-dominant, et ce, même dans le cas de couches géologiques du bassin sédimentaire fines et/ou présentant un biseau.

Par ailleurs, le procédé selon le deuxième aspect de l'invention permet de prédire le potentiel pétrolier de bassins sédimentaires complexes, ayant par exemple subi des mouvements tectoniques complexes et présentant des couches fines et/ou des biseaux stratigraphiques, ce qui contribue à améliorer l'exploitation des hydrocarbures de ce type de bassins sédimentaires.

**Revendications**

1. Procédé de modélisation d'un bassin sédimentaire, ledit bassin sédimentaire ayant subi une pluralité d'événements géologiques définissant une séquence d'états dudit bassin, au moyen d'une simulation numérique de bassin exécutée sur ordinateur, ladite simulation numérique de bassin résolvant au moins une équation d'équilibre de la poromécanique selon une méthode aux éléments finis lissée basée sur les faces pour déterminer au moins un champ de contrainte et un champ de déformation, **caractérisé en ce que** le procédé comprend la mise en oeuvre d'au moins les étapes suivantes :

A. on réalise des mesures de grandeurs physiques relatives audit bassin au moyen de capteurs, et on construit une représentation maillée représentative dudit bassin pour chacun desdits états dudit bassin, lesdites représentations maillée dudit bassin pour chacun desdits états étant majoritairement formées par des mailles hexaédriques ;

B. au moyen de ladite simulation numérique de bassin et desdites représentations maillées pour chacun desdits états, on détermine au moins un champ de déformation et un champ de contrainte pour chacun desdits états en appliquant au moins les étapes suivantes pour chacune desdites représentations maillées desdits états :

a) on subdivise chacune desdites mailles hexaédriques de ladite représentation maillée en au moins huit sous-mailles hexaédriques ;

b) pour chacune des faces de chacune desdites sous-mailles, on détermine un domaine de lissage selon la méthode des éléments finis lissée basée sur les faces appliquée auxdites sous-mailles ;

c) pour chacun desdits domaines de lissage, on détermine une relation entre déformations et déplacements selon la méthode des éléments finis lissée basée sur les faces appliquée auxdits domaines de lissage ;

d) pour chacun desdits domaines de lissage, on détermine une relation de passage entre les degrés de liberté des noeuds desdites sous-mailles qui contiennent ledit domaine de lissage et les degrés de liberté des noeuds de ladite au moins une maille à laquelle appartient lesdites sous-mailles ;

e) on détermine une rigidité et des forces nodales pour chacun desdits domaines de lissage à partir au moins de ladite relation de passage déterminée pour ledit domaine de lissage et de ladite relation entre déformations et déplacements déterminée pour ledit domaine de lissage ;

f) on détermine une rigidité et des forces nodales relatives à ladite représentation maillée à partir au moins de ladite rigidité et desdites forces nodales déterminées pour chacun desdits domaines de lissage ;

g) on modélise le bassin sédimentaire en déterminant au moins ledit champ de déplacement et ledit champ des contraintes pour ladite représentation maillée, au moyen de ladite simulation numérique de bassin et au moins de ladite rigidité et desdites forces nodales déterminées pour ladite représentation maillée.

2. Procédé selon la revendication 1, dans lequel on subdivise chacune desdites mailles hexaédriques de ladite représentation maillée en huit sous-mailles hexaédriques, ladite subdivision d'une desdites mailles étant réalisée de manière à ce que chaque face de ladite maille soit constituée par quatre faces de quatre sous-mailles parmi lesdites huit sous-mailles.

3. Procédé selon l'une des revendications précédentes, dans lequel, à l'étape b), on détermine ledit domaine de lissage relatif à une desdites faces appartenant à au moins une desdites sous-mailles en connectant chaque noeud de ladite face avec au moins un point placé au barycentre de la ou des sous-mailles auxquelles appartient ladite face.

4. Procédé selon la revendication 3, dans lequel ladite relation entre déformations et déplacements est une matrice de transformation reliant un vecteur des déplacements à un vecteur des déformations selon une formule s'écrivant :

$$B = [\, B_1 B_2 \dots B_{n-1} B_n ]$$

avec

$$B_i = \frac{1}{A_k^S} \int_{\partial \Omega_k^S} n N_i \, d\Gamma$$

où $B_i$ est une matrice associée respectivement au noeud i, avec i=1..n, de ladite ou desdites sous-mailles auxquelles appartient ledit domaine de lissage $\Omega_k^S$, $A_k^S$ est le volume dudit domaine de lissage $\Omega_k^S$, $\partial \Omega_k^S$ est une frontière dudit domaine de lissage, n est une normale sortante dudit domaine de lissage $\Omega_k^S$ et Ni est une fonction de forme associée au noeud i.

5. Procédé selon la revendication 4, dans lequel ladite relation de passage pour un domaine de lissage relatif à une desdites faces d'au moins une desdites sous-mailles est une matrice de passage déterminée en fonction au moins des matrices de fonctions de forme de l'élément fini affecté à ladite ou les dites sous-mailles auxquelles appartient ledit domaine de lissage, lesdites matrices des fonctions de forme étant évaluées en chacun des noeuds de ladite ou desdites sous-mailles auxquelles appartient ledit domaine de lissage.

6. Procédé selon la revendication 5, dans lequel ladite rigidité et lesdites forces nodales pour chacun desdits domaines de lissage prennent la forme respectivement d'une matrice de rigidité et d'un vecteur des forces nodales, et dans lequel ladite matrice de rigidité $K_{\Omega virt}$ et ledit vecteur des forces nodales $\mathbf{f}_{\Omega virt}$ pour un desdits domaines de lissage $\Omega_{virt}$ sont déterminés respectivement selon des formules s'écrivant :

$$K_{\Omega_{virt}} = \int_{\Omega_{virt}} T_{\Omega_{virt}}^T B_{\Omega_{virt}}^T D B_{\Omega_{virt}} T_{\Omega_{virt}} dV$$

$$f_{\Omega_{virt}} = -\int_{\Omega_{virt}} N^T b dV - \int_{\partial\Omega_{virt}} N^T \bar{t} dA - \int_{\Omega_{virt}} T_{\Omega_{virt}}^T B_{\Omega_{virt}}^T D \varepsilon_0 dV + \int_{\Omega_{virt}} T_{\Omega_{virt}}^T B_{\Omega_{virt}}^T \sigma_0 dV$$

dans lesquelles $T_{\Omega virt}$ est ladite matrice de passage pour ledit domaine de lissage $\Omega_{virt}$, $B_{\Omega virt}$ est ladite matrice de transformation pour ledit domaine de lissage $\Omega_{virt}$, N est une matrice desdites fonctions de forme, D est une matrice représentative de la rigidité du matériau, b est un vecteur des forces volumiques, t est un vecteur des forces surfaciques, $\varepsilon_0$ est une déformation initiale et $\sigma_0$ une contrainte résiduelle initiale.

7. Procédé selon la revendication 6, dans lequel, à l'étape f) et si l'ensemble desdites mailles de ladite représentation maillée sont hexaédriques, on détermine ladite rigidité et lesdites forces nodales relatives à ladite représentation maillée selon des formules respectives s'écrivant :

$$K = \sum_{i=1}^{nv} K_{\Omega_{virt\,i}}$$

$$f = \sum_{i=1}^{nv} f_{\Omega_{virt\,i}}$$

où nv est le nombre total desdits domaines de lissage.

8. Produit programme d'ordinateur téléchargeable depuis un réseau de communication et/ou enregistré sur un support lisible par ordinateur et/ou exécutable par un processeur, comprenant des instructions de code de programme pour la mise en oeuvre de l'étape B) du procédé selon l'une des revendications 1 à 7, lorsque ledit programme est exécuté sur un ordinateur.

9. Procédé pour exploiter des hydrocarbures présents dans un bassin sédimentaire, ledit procédé comprenant au moins la mise en oeuvre du procédé de modélisation dudit bassin selon l'une des revendications 1 à 7, et dans lequel, à partir au moins de ladite modélisation dudit bassin sédimentaire, on détermine un schéma d'exploitation dudit bassin comprenant au moins une implantation d'au moins un puits injecteur et/ou d'au moins un puits producteur, et on exploite lesdits hydrocarbures dudit bassin au moins en forant lesdits puits de ladite implantation et en les équipant d'infrastructures d'exploitation.

**Patentansprüche**

1. Verfahren zur Modellierung eines Sedimentbeckens, wobei das Sedimentbecken eine Vielzahl geologischer Ereignisse erfahren hat, die eine Folge von Zuständen des Beckens definieren, mittels einer auf einem Computer ausgeführten digitalen Beckensimulation, wobei die digitale Beckensimulation mindestens eine Gleichgewichtsgleichung der Poromechanik gemäß einer geglätteten Finite-Elemente-Methode basierend auf den Seiten löst, um mindestens ein Spannungsfeld und ein Verformungsfeld zu bestimmen, **dadurch gekennzeichnet, dass** das Verfahren die Durchführung mindestens der folgenden Schritte enthält:

A. Messungen physikalischer Größen bezüglich des Beckens werden mittels Sensoren durchgeführt, und es wird eine repräsentative vermaschte Darstellung des Beckens für jeden der Zustände des Beckens konstruiert, wobei die vermaschten Darstellungen des Beckens für jeden der Zustände mehrheitlich von hexaedrischen Maschen geformt werden;

B. mittels der digitalen Beckensimulation und der vermaschten Darstellungen für jeden der Zustände werden mindestens ein Verformungsfeld und ein Spannungsfeld für jeden der Zustände bestimmt, indem mindestens die folgenden Schritte für jede der vermaschten Darstellungen der Zustände angewendet werden:

a) jede der hexaedrischen Maschen der vermaschten Darstellung wird in mindestens acht hexaedrische Teilmaschen unterteilt;

b) für jede der Seiten jeder der Teilmaschen wird ein Glättungsbereich gemäß der geglätteten Finite-Elemente-Methode basierend auf den Seiten bestimmt, die auf die Teilmaschen angewendet wird;

c) für jeden der Glättungsbereiche wird eine Beziehung zwischen Verformungen und Verschiebungen gemäß der geglätteten Finite-Elemente-Methode basierend auf den Seiten bestimmt, die auf die Glättungsbereiche angewendet wird;

d) für jeden der Glättungsbereiche wird eine Übergangsbeziehung zwischen den Freiheitsgraden der Knoten der Teilmaschen, die den Glättungsbereich enthalten, und den Freiheitsgraden der Knoten der mindestens einen Masche bestimmt, zu der die Teilmaschen gehören;

e) eine Steifheit und Knotenkräfte werden für jeden der Glättungsbereiche ausgehend mindestens von der für den Glättungsbereich bestimmten Übergangsbeziehung und der für den Glättungsbereich bestimmten Beziehung zwischen Verformungen und Verschiebungen bestimmt;

f) eine Steifheit und Knotenkräfte bezüglich der vermaschten Darstellung werden ausgehend mindestens von der Steifheit und den Knotenkräften bestimmt, die für jeden der Glättungsbereiche bestimmt sind;

g) das Sedimentbecken wird durch Bestimmung mindestens des Verschiebungsfelds und des Spannungsfelds für die vermaschte Darstellung mittels der digitalen Beckensimulation und mindestens der Steifheit und der bestimmten Knotenkräfte für die vermaschte Darstellung modelliert.

2. Verfahren nach Anspruch 1, wobei jede der hexaedrische Maschen der vermaschten Darstellung in acht hexaedrische Teilmaschen unterteilt wird, wobei die Unterteilung einer der Maschen so durchgeführt wird, dass jede Seite der Masche aus vier Seiten von vier Teilmaschen unter den acht Teilmaschen besteht.

3. Verfahren nach einem der vorhergehenden Ansprüche, wobei im Schritt b) der Glättungsbereich bezüglich einer der Seiten, die zu mindestens einer der Teilmaschen gehören, bestimmt wird, indem jeder Knoten der Seite mit mindestens einem Punkt verbunden wird, der im Baryzentrum der Teilmasche(n) platziert ist, zu denen die Seite gehört.

4. Verfahren nach Anspruch 3, wobei die Beziehung zwischen Verformungen und Verschiebungen eine Transformationsmatrix ist, die einen Vektor der Verschiebungen mit einem Vektor der Verformungen gemäß einer Formel verbindet, die folgendermaßen geschrieben wird:

$$B \;=\; [\,B_1 B_2 \;\ldots\; B_{n-1} B_n\,]$$

mit

$$B_i = \frac{1}{A_k^s} \int_{\partial\Omega_k^s} n N_i \, d\,\Gamma$$

wobei $B_i$ eine dem Knoten i mit i=1...n zugeordnete Matrix der Teilmasche(n) ist, zu denen der Glättungsbereich $\Omega_k^s$ gehört, $A_k^s$ das Volumen des Glättungsbereichs $\Omega_k^s$ ist, $\partial\Omega_k^s$ eine Grenze des Glättungsbereichs ist, n eine ausgehende Normale des Glättungsbereichs $\Omega_k^s$ und Ni eine dem Knoten i zugeordnete Formfunktion ist.

5. Verfahren nach Anspruch 4, wobei die Übergangsbeziehung für einen Glättungsbereich bezüglich einer der Seiten mindestens einer der Teilmaschen eine Übergangsmatrix ist, bestimmt abhängig mindestens von den Matrizen von Formfunktionen des finiten Elements, das der oder den Teilmasche(n) zugewiesen ist, zu denen der Glättungsbereich gehört, wobei die Matrizen der Formfunktionen in jedem der Knoten der Teilmasche(n) bewertet werden, zu denen der Glättungsbereich gehört.

6. Verfahren nach Anspruch 5, wobei die Steifheit und die Knotenkräfte für jeden der Glättungsbereiche die Form einer Steifheitsmatrix bzw. eines Vektors der Knotenkräfte annehmen, und wobei die Steifheitsmatrix $K_{\Omega virt}$ und der Vektor der Knotenkräfte $f_{\Omega virt}$ für einen der Glättungsbereiche $\Omega_{virt}$ je gemäß Formeln bestimmt werden, die folgendermaßen geschrieben werden:

$$K_{\Omega_{virt}} = \int_{\Omega_{virt}} T_{\Omega_{virt}}^T B_{\Omega_{virt}}^T DB_{\Omega_{virt}} T_{\Omega_{virt}} dV$$

$$f_{\Omega_{virt}} = -\int_{\Omega_{virt}} N^T b dV - \int_{\partial\Omega_{virt}} N^T \bar{t} dA - \int_{\Omega_{virt}} T_{\Omega_{virt}}^T B_{\Omega_{virt}}^T D\varepsilon_0 dV + \int_{\Omega_{virt}} T_{\Omega_{virt}}^T B_{\Omega_{virt}}^T \sigma_0 dV$$

in denen $T_{\Omega virt}$ die Übergangsmatrix für den Glättungsbereich $\Omega_{virt}$, $B_{\Omega virt}$ die Transformationsmatrix für den Glättungsbereich $\Omega_{virt}$, N eine Matrix der Formfunktionen, D eine für die Steifheit des Materials repräsentative Matrix, b ein Vektor der Volumenkräfte, t ein Vektor der flächenbezogenen Kräfte, $\varepsilon_0$ eine Ausgangsverformung und $\sigma_0$ eine Ausgangsrestspannung ist.

7. Verfahren nach Anspruch 6, wobei im Schritt f), und wenn die Gesamtheit der Maschen der vermaschten Darstellung hexaedrisch ist, die Steifheit und die Knotenkräfte bezüglich der vermaschten Darstellung gemäß Formeln bestimmt werden, die folgendermaßen geschrieben werden:

$$K = \sum_{i=1}^{nv} K_{\Omega_{virt\,i}}$$

$$f = \sum_{i=1}^{nv} f_{\Omega_{virt\,i}}$$

wobei nv die Gesamtanzahl der Glättungsbereiche ist.

8. Computerprogrammprodukt, das von einem Kommunikationsnetz herunterladbar und/oder auf einem computerlesbaren Träger gespeichert und/oder von einem Prozessor ausführbar ist, das Programmcodeanweisungen für die Durchführung des Schritts B) des Verfahrens nach einem der Ansprüche 1 bis 7 enthält, wenn das Programm auf einem Computer ausgeführt wird.

9. Verfahren zur Gewinnung von in einem Sedimentbecken vorhandenen Kohlenwasserstoffen, wobei das Verfahren mindestens die Durchführung des Modellierungsverfahrens des Beckens nach einem der Ansprüche 1 bis 7 enthält, und wobei ausgehend von der mindestens einen Modellierung des Sedimentbeckens ein Gewinnungsplan des Beckens bestimmt wird, der mindestens einen Einbauort mindestens einer Injektionsbohrung und/oder mindestens einer Produktionsbohrung enthält, und die Kohlenwasserstoffe aus dem Becken gewonnen werden, indem mindestens die Bohrungen des Einbauorts gebohrt werden und indem sie mit Gewinnungsinfrastrukturen ausgestattet werden.

## Claims

1. Process for modelling a sedimentary basin, said sedimentary basin having undergone a plurality of geological events defining a sequence of states of said basin, by means of a digital basin simulation executed on a computer, said digital basin simulation solving at least one poromechanics equilibrium equation according to a face-based smoothed finite element method in order to determine at least one strain field and one deformation field, **characterized in that** the process comprises implementing at least the following steps:

A. measurements are made of physical quantities relating to said basin by means of sensors, and a meshed representation which is representative of said basin is constructed for each of said states of said basin, said meshed representations of said basin for each of said states being predominantly formed by hexahedral meshes;

B. by means of said digital basin simulation and said meshed representations for each of said states, at least one deformation field and one strain field are determined for each of said states by applying at least the following steps for each of said meshed representations of said states:

a) each of said hexahedral meshes of said meshed representation is subdivided into at least eight hexahedral submeshes;

b) for each of the faces of each of said submeshes, a smoothing domain is determined according to the face-based smoothed finite element method applied to said submeshes;

c) for each of said smoothing domains, a relationship between deformations and displacements is determined according to the face-based smoothed finite element method applied to said smoothing domains;

d) for each of said smoothing domains, a relationship for switching between the degrees of freedom of the nodes of said submeshes which contain said smoothing domain and the degrees of freedom of the nodes of said at least one mesh to which said submeshes belong is determined;

e) a stiffness and nodal forces for each of said smoothing domains are determined on the basis of at least said switching relationship determined for said smoothing domain and said relationship between deformations and displacements which is determined for said smoothing domain;

f) a stiffness and nodal forces relating to said meshed representation are determined on the basis of at least said stiffness and said nodal forces determined for each of said smoothing domains;

g) the sedimentary basin is modelled by determining at least said displacement field and said strain field for said meshed representation, by means of said digital basin simulation and of at least said stiffness and said nodal forces determined for said meshed representation.

2. Process according to Claim 1, wherein each of said hexahedral meshes of said meshed representation is subdivided into eight hexahedral submeshes, one of said meshes being subdivided so that each face of said mesh is formed by four faces of four submeshes from among said eight submeshes.

3. Process according to one of the preceding claims, wherein, in step b), said smoothing domain relating to one of said faces belonging to at least one of said submeshes is determined by connecting each node of said face to at least one point placed at the barycentre of the one or more submeshes to which said face belongs.

4. Process according to Claim 3, wherein said relationship between deformations and displacements is a transformation matrix linking a vector of the displacements to a vector of the deformations according to a formula which is written:

$$B = [B_1 B_2 \dots B_{n-1} B_n]$$

with

$$B_i = \frac{1}{A_k^S} \int_{\partial \Omega_k^S} n N_i d\Gamma$$

where $B_i$ is a matrix associated respectively with the node i, with i=1...n, of said one or more submeshes to which said smoothing domain $\Omega_k^S$ belongs, $A_k^S$ is the volume of said smoothing domain $\Omega_k^S$, $\partial \Omega_k^S$ is a boundary of said smoothing domain, n is a normal emerging from said smoothing domain $\Omega_k^S$ and Ni is a shape function associated with the node i.

5. Process according to Claim 4, wherein said switching relationship for a smoothing domain relating to one of said faces of at least one of said submeshes is a switching matrix determined as a function of at least matrices of shape functions of the finite element which is assigned to said one or more submeshes to which said smoothing domain belongs, said matrices of the shape functions being evaluated at each of the nodes of said one or more submeshes to which said smoothing domain belongs.

6. Process according to Claim 5, wherein said stiffness and said nodal forces for each of said smoothing domains take the form of a stiffness matrix and of a vector of nodal forces, respectively, and wherein said stiffness matrix $K_{\Omega virt}$ and said vector of the nodal forces $f_{\Omega virt}$ for one of said smoothing domains $\Omega_{virt}$ are determined according to formulae which are written:

$$K_{\Omega_{virt}} = \int_{\Omega_{virt}} T_{\Omega_{virt}}^T B_{\Omega_{virt}}^T D B_{\Omega_{virt}} T_{\Omega_{virt}} dV$$

$$f_{\Omega_{virt}} = -\int_{\Omega_{virt}} N^T b \, dV - \int_{\partial\Omega_{virt}} N^T \bar{t} \, dA - \int_{\Omega_{virt}} T_{\Omega_{virt}}^T B_{\Omega_{virt}}^T D \varepsilon_0 \, dV$$

$$+ \int_{\Omega_{virt}} T_{\Omega_{virt}}^T B_{\Omega_{virt}}^T \sigma_0 \, dV$$

respectively, in which $T_{\Omega virt}$ is said switching matrix for said smoothing domain $\Omega_{virt}$, $B_{\Omega virt}$ is said transformation matrix for said smoothing domain $\Omega_{virt}$, N is a matrix of said shape functions, D is a matrix which is representative of the stiffness of the material, b is a vector of the body forces, t is a vector of the surface forces, $\varepsilon_0$ is an initial deformation and $\sigma_0$ is an initial residual strain.

7. Process according to Claim 6, wherein, in step f) and if all of said meshes of said meshed representation are hexahedral, said stiffness and said nodal forces relating to said meshed representation are determined according to respective formulae which are written:

$$K = \sum_{i=1}^{nv} K_{\Omega_{virt\,i}}$$

$$f = \sum_{i=1}^{nv} f_{\Omega_{virt\,i}}$$

where nv is the total number of said smoothing domains.

8. Computer program product which can be downloaded from a communication network and/or is stored on a medium which can be read by a computer and/or can be executed by a processor, comprising program code instructions for implementing step B) of the process according to one of Claims 1 to 7, when said program is executed on a computer.

9. Process for exploiting the hydrocarbons which are present in a sedimentary basin, said process comprising at least implementing the process for modelling said basin according to one of Claims 1 to 7, and wherein, on the basis of at least said modelling of said sedimentary basin, an exploitation scheme for said basin is determined, comprising at least one site of at least one injection well and/or of at least one production well, and said hydrocarbons of said basin are exploited at least by drilling said wells of said site and by equipping them with exploitation infrastructures.

[Fig. 1]

[Fig 2]

[Fig 3]

[Fig 4]

[Fig 5]

[Fig 6]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2110686 A
- US 8150669 B
- EP 2816377 A
- US 20140377872 A
- EP 3075947 A
- US 20160290107 A
- EP 3182176 A
- US 20170177764 A
- US 10296679 B
- FR 2930350 A1
- US 20090265152 A1

**Littérature non-brevet citée dans la description**

- **COOK, ROBERT D.** Finite Elément Modeling for Stress Analysis. John Wiley & Sons, 1995
- **COUSSY, O.** Mécanique des milieux poreux. 1991
- **LIU, G.R. ; NGUYEN THOI TRUNG.** Smoothed Finite Element Methods. CRC Press, 2010
- **SCHNEIDER F.** Modelling multi-phase flow of petroleum at the sedimentary basin scale. *Journal of Geochemical exploration,* 2003, vol. 78-79, 693-696
- **STECKLER, M.S. ; A.B. WATTS.** Subsidence of the Atlantic-type continental margin off New York. *Earth Planet. Sci. Lett.,* 1978, vol. 41, 1-13
- the basis. **ZIENKIEWICZ, O.C. ; TAYLOR, R.L.** The finite element method. Butterworth, 2000, vol. 1
- **LI Y.H. et al.** Highly accurate smoothed finite element methods based on simplified eight-noded hexahedron éléments. *Engenieering Analysis with Boundary Elements,* Août 2019, vol. 105, 165-177